# FASCICULE DE BREVET EUROPEEN

(11) **EP 0 951 145 B1**
(45) Date de publication et mention de la délivrance du brevet: **03.03.2004**
(21) Numéro de dépôt: 99400879.5
(22) Date de dépôt: 09.04.1999
(51) Int. Cl.: H03K 5/08, H03K 5/1252

(54) **Circuit pour l'acquisition de signaux analogiques binaires**
Schaltung zur Erfassung von analogen binären Signalen
Circuit for the acquisition of analog binary signals

(30) Priorité: 17.04.1998 FR 9804859
(43) Date de publication de la demande: 20.10.1999
(73) Titulaire: THALES AVIONICS S.A., 78141 Vélizy Villacoublay Cédex (FR)
(72) Inventeur: Bieth, Philippe, 94117 Arcueil Cedex (FR); Pitot, Christian, 94117 Arcueil Cedex (FR); Prost, Michel, 94117 Arcueil Cedex (FR)
(74) Mandataire: Beylot, Jacques

(56) Documents cités:
- EP-A- 0 601 750
- EP-A- 0 664 612
- WO-A-93/12579
- DE-A- 3 837 821
- US-A- 4 418 332
- US-A- 5 202 589
- PATENT ABSTRACTS OF JAPAN vol. 003, no. 085 (E-124), 21 juillet 1979 & JP 54 061863 A (FUJITSU LTD), 18 mai 1979

## Description

La présente invention telle que définie dans les revendications concerne l'acquisition de signaux analogiques binaires en entrée d'un circuit intégré numérique.

Le dialogue entre un calculateur et ses périphériques, ou entre plusieurs calculateurs, ou encore entre un opérateur humain et un calculateur, se fait fréquemment au moyen de signaux électriques analogiques discrets ou booléens évoluant autour de deux seuils de tension qui sont plus ou moins écartés en fonction des marges de bruit tolérées. On se retrouve alors avec des tensions mises en jeu qui peuvent être importantes vis à vis des tensions habituellement admises dans les technologies d'intégration numériques les plus courantes aujourd'hui (tension de 5V) de sorte qu'il faut réaliser une adaptation de tension. Celle-ci fait traditionnellement appel à un étage d'interface analogique à pont diviseur résistif incorporant éventuellement une capacité de filtrage. L'adaptation de tension réalisée, il faut déterminer l'état binaire du signal en comparant sa tension instantanée à un niveau de référence. Cela s'obtient en soumettant le signal issu de l'étage d'interface analogique à un comparateur de niveau réalisé en technologie numérique. Comme les pentes d'évolution des signaux acquis par l'intermédiaire d'un étage d'interface analogique sont souvent très lentes devant les vitesses de commutation des technologies numériques actuelles, il y a un grand risque de mettre en oscillation l'étage d'entrée numérique avec pour conséquence une consommation accrue, un fonctionnement hasardeux et enfin une fiabilité pouvant s'en trouver diminuée. Pour pallier à cela, il est connu d'utiliser, à la place de simples comparateurs de niveau, des triggers de Schmitt qui présentent une hystérésis de basculement avec deux seuils distincts : un seuil haut à la montée et un seuil bas à la descente.

L'étage numérique d'entrée à trigger de Schmitt est réalisé dans une cellule du circuit intégré numérique. De ce fait, il a l'inconvénient d'avoir ses caractéristiques électriques, donc ses seuils de basculement, figées lors de la caractérisation de sa cellule d'intégration. Or, dans les technologies d'intégration, la caractérisation des cellules est une opération coûteuse que l'on cherche à éviter le plus possible. C'est ainsi qu'il est habituel de définir l'architecture d'un circuit intégré numérique ASIC (Application Specific Integrated Circuit en langage anglo-saxon) prédiffusé ou précaractérisé, à partir d'une combinaison de cellules précaractérisées de divers types, établies à l'avance et regroupées en bibliothèque. Le concepteur d'un circuit ASIC n'a donc, pour discrétiser un signal analogique binaire, qu'un choix parmi un jeu réduit de plusieurs types d'étages numériques d'entrée à trigger de Schmitt aux caractéristiques figées, jeu souvent limité à deux types, l'un au standard TTL, l'autre au standard CMOS. Il arrive quelquefois, que parmi le jeu d'étages numériques d'entrée à trigger de Schmitt disponibles, aucun ne convienne réellement de sorte que, sauf à faire développer une cellule spécifique, ce qui est coûteux, le concepteur d'un circuit ASIC doit opter pour un type disponible d'étage d'entrée numérique à trigger de Schmitt ayant des seuils de basculement haut et bas qui ne sont pas ceux souhaités mais qui leur sont simplement proches. Le circuit intégré numérique obtenu manifeste alors une plus grande sensibilité au bruit ou nécessite un étage d'adaptation plus complexe.

La présente invention a pour but de lutter contre cet inconvénient en augmentant, pour un concepteur de circuit intégré numérique ASIC, les possibilités de choix des niveaux de seuils de basculement haut et bas d'un étage numérique d'entrée malgré la limitation imposée par un nombre réduit de types d'étage numérique d'entrée à trigger de Schmitt précaractérisés en bibliothèque.

Elle a pour objet un circuit pour l'acquisition d'un signal analogique binaire comportant en entrée plusieurs triggers de Schmitt avec des seuils de basculement différents, connectés en parallèle par leurs entrées, et suivis d'au moins un circuit logique de discrétisation déduisant l'état du signal analogique binaire de la combinaison des états de sortie des triggers de Schmitt d'entrée.

Avantageusement, le circuit logique de discrétisation comporte des moyens de rétroaction permettant un forçage temporaire du niveau de signal en entrées des triggers de Schmitt.

Le circuit logique de discrétisation peut être utilisé pour augmenter ou diminuer l'hystérésis apparent de deux triggers de Schmitt ayant des seuils haut et bas de basculement étagés. Lorsqu'il est utilisé pour augmenter l'hystérésis apparent, il comporte une bascule logique changeant d'état d'une part, lors du passage au niveau logique 1 du trigger de Schmitt ayant le seuil haut de basculement le plus élevé et d'autre part lors du passage au niveau logique 0 du trigger de Schmitt ayant le seuil bas de basculement le plus bas. Lorsqu'il est utilisé pour diminuer l'hystérésis apparent de deux triggers de Schmitt ayant des seuils haut et bas de basculement étagés, il comporte une bascule logique changeant d'état d'une part, lors du passage au niveau logique 0 du trigger de Schmitt ayant le seuil bas de basculement le plus élevé et, d'autre part, lors du passage au niveau logique 1 du trigger de Schmitt ayant le seuil haut de basculement le plus bas et des moyens de rétroaction forçant un court instant le trigger de Schmitt à seuil haut de basculement le plus élevé au franchissement de son seuil haut dés franchissement en montant du seuil haut de l'autre trigger de Schmitt par le signal d'entrée, et le trigger de Schmitt au seuil bas de basculement le plus bas au franchissement de son seuil bas dès franchissement en descendant du seuil bas de l'autre trigger de Schmitt par le signal d'entrée.

Le circuit logique de discrétisation en permettant de sélectionner un des triggers de Schmitt d'entrée pour le franchissement à la montée de son seuil haut et un autre pour le franchissement à la descente de son seuil bas tout en assurant, lorsque cela se révèle nécessaire, une rétroaction garantissant la sensibilité de ces deux triggers de Schmitt aux passages de ces deux seuils fait plus que doubler la liberté de choix du concepteur de circuit intégré numérique ASIC, cette liberté de choix étant d'autant plus grande que le nombre de types de trigger de Schmitt d'entrée est élevé.

Avantageusement, le circuit pour l'acquisition d'un signal analogique binaire fait partie d'un circuit intégré numérique en boîtier et a ses différents triggers de Schmitt d'entrée raccordés en entrée à une même broche de connexion du boîtier du circuit intégré numérique.

Avantageusement, le circuit intégré numérique en boîtier comporte plusieurs exemplaires de circuit pour l'acquisition d'un signal analogique binaire ayant chacun leurs différents triggers de Schmitt d'entrée raccordés en entrée à une même broche du boîtier du circuit intégré numérique et des moyens de test individuel de chacun des seuils des triggers à base de chaînes de portes logiques de type "non et" connectées chacune en sorties d'un même type de triggers de Schmitt.

Avantageusement, le circuit pour l'acquisition d'un signal analogique binaire comporte, en plus des triggers de Schmitt avec des seuils de basculement différents, connectés en parallèle par leurs entrées, et du circuit logique de discrétisation qui est connecté aux sorties des triggers de Schmitt et qui déduit l'état du signal analogique binaire de la combinaison des états de sortie des triggers de Schmitt, un filtre numérique de sortie éliminant les bruits transitoires provoqués par les fonctionnements asynchrones des différents triggers de Schmitt.

Avantageusement, le circuit pour l'acquisition d'un signal analogique binaire comporte, en plus des triggers de Schmitt avec des seuils de basculement différents, connectés en parallèle par leurs entrées, et du circuit logique de discrétisation qui est connecté aux sorties des triggers de Schmitt et qui déduit l'état du signal analogique binaire de la combinaison des états de sortie des triggers de Schmitt, des moyens de détection de panne détectant les combinaisons interdites entre états de sortie des différents triggers de Schmitt.

Avantageusement, le circuit pour l'acquisition d'un signal analogique binaire comporte, en plus des triggers de Schmitt avec des seuils de basculement différents, connectés en parallèle par leurs entrées, et du circuit logique de discrétisation qui est connecté aux sorties des triggers de Schmitt et qui déduit l'état du signal analogique binaire de la combinaison des états de sortie des triggers de Schmitt, des moyens de détection de panne détectant les combinaisons interdites entre états de sortie des différents triggers de Schmitt et se déclenchant uniquement en cas de maintien de combinaisons interdites entre états de sortie des différents triggers de Schmitt au delà d'une certaine durée.

Avantageusement, le circuit pour l'acquisition d'un signal analogique binaire comporte plusieurs circuits logiques de discrétisation différents et un circuit de sélection de la sortie de l'un au choix de ces circuits logiques de discrétisation.

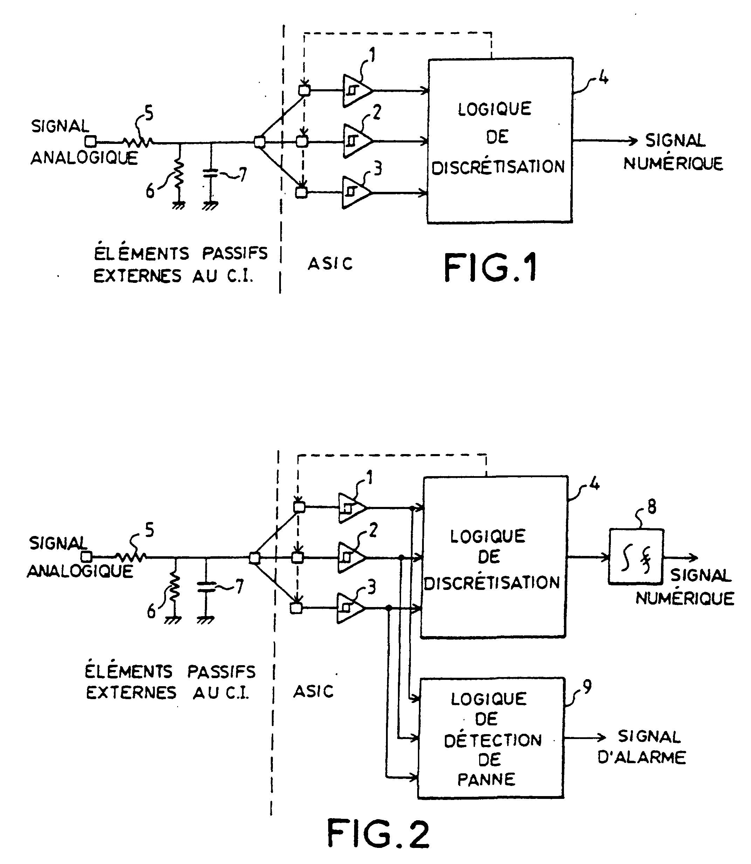

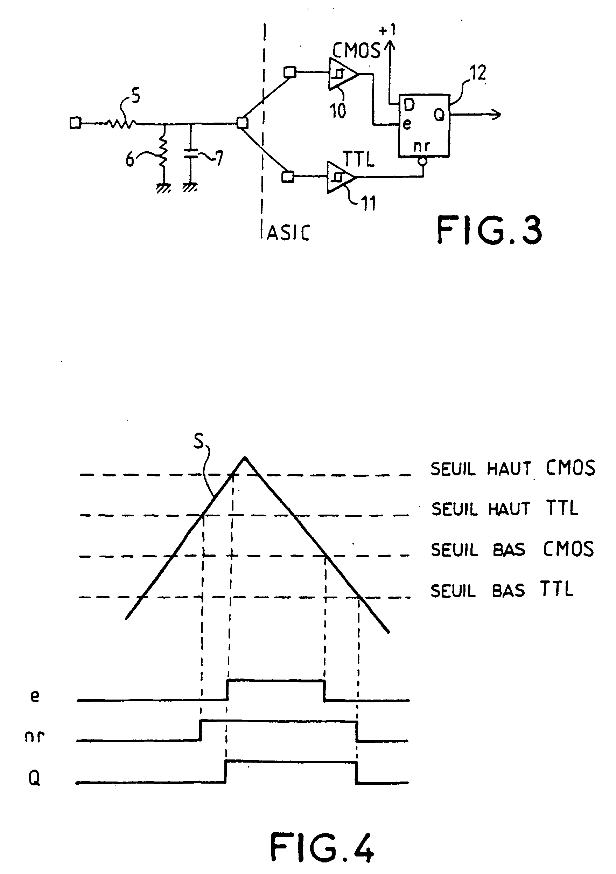

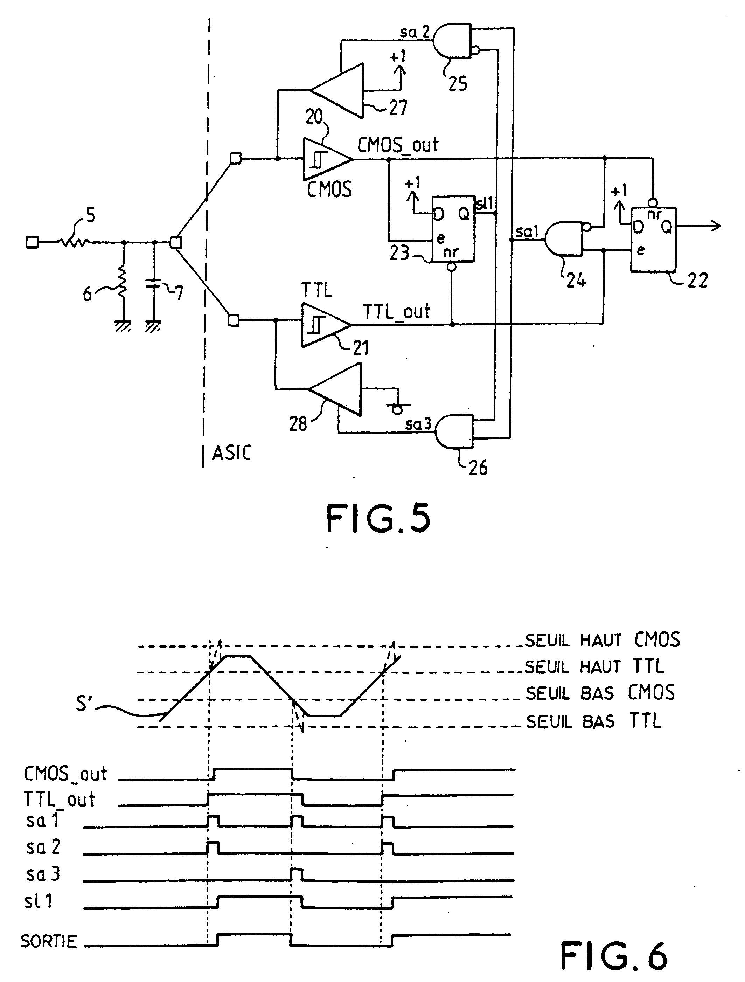

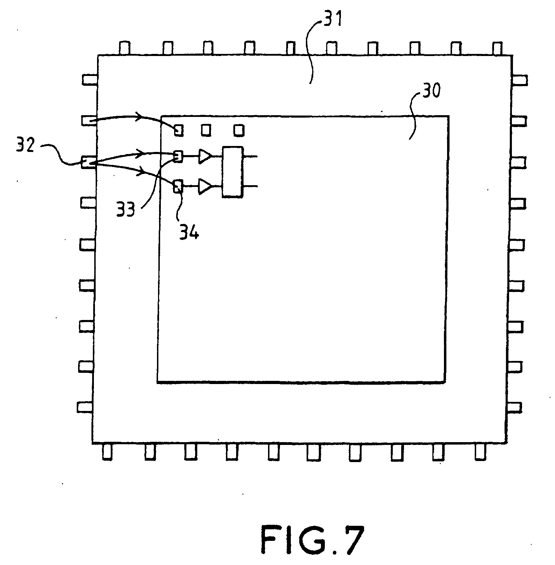

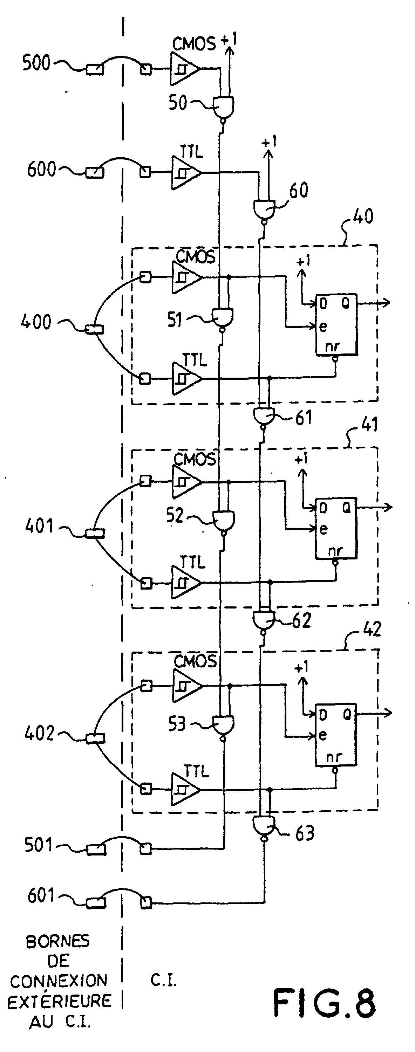

D'autres avantages et caractéristiques de l'invention ressortiront de la description ci-après de plusieurs modes de réalisation donnés à titre d'exemple. Cette description sera faite en regard du dessin dans lequel :
- une figure 1 est un schéma de principe général d'un circuit pour l'acquisition d'un signal analogique binaire selon l'invention précédé d'un pont diviseur de tension résistif réalisant une adaptation de tension,
- une figure 2 est un schéma d'un circuit conforme à celui de la figure 1, complété par un filtre numérique antibruit et par un circuit de détection de panne,
- une figure 3 est un schéma d'un circuit pour l'acquisition d'un signal analogique binaire selon l'invention comportant deux types de trigger en entrée, l'un répondant au standard CMOS, l'autre répondant au standard TTL et un circuit logique de discrétisation à base d'un registre de mémorisation permettant de sélectionner le seuil haut CMOS et le seuil bas TTL,
- une figure 4 est un diagramme de courbes illustrant le fonctionnement du circuit de la figure 3,
- une figure 5 est un schéma d'un circuit pour l'acquisition d'un signal analogique binaire selon l'invention comportant deux types de trigger en entrée, l'un répondant au standard CMOS, l'autre au standard TTL et un circuit logique de discrétisation à base de registres de mémorisation et de portes logiques permettant de sélectionner le seuil haut TTL et le seuil bas CMOS,
- une figure 6 est un diagramme de courbes illustrant le fonctionnement du circuit de la figure 5,
- une figure 7 est un schéma illustrant le câblage des plages de connexion d'une puce de circuit intégré ASIC aux plots de connexion de son boîtier dans le cas des entrées de trigger d'un circuit pour l'acquisition d'un signal analogique binaire selon l'invention, et
- une figure 8 est un schéma illustrant la configuration d'un dispositif logique de test pour le test des triggers d'entrée d'un circuit pour l'acquisition d'un signal analogique binaire selon l'invention.

Le circuit pour l'acquisition d'un signal analogique binaire qui va être décrit, est intégré sur la puce d'un circuit numérique ASIC. Il est représenté sur la figure 1 derrière un étage analogique purement passif, extérieur à la puce du circuit intégré numérique ASIC, mettant la gamme de variation de tension du signal analogique binaire à l'échelle de la plage de variation de tension admise par le circuit intégré numérique ASIC. Il comporte essentiellement, un étage d'entrée constitué d'un banc de triggers de Schmitt 1, 2, 3 de différents types dont les entrées sont connectées en parallèle, et un étage de sortie constitué d'un circuit logique de discrétisation 4 déduisant l'état du signal analogique binaire de la combinaison des états de sortie du banc de triggers de Schmitt d'entrée 1, 2, 3 et agissant éventuellement sur le signal d'entrée (connexion de rétroaction en pointillés) pour sensibiliser les triggers de Schmitt.

L'étage analogique passif d'entrée, qui est extérieur au circuit intégré numérique ASIC, est constitué, de la manière habituelle par un pont diviseur de tension à deux résistances 5, 6 complété par une capacité de filtrage 7. Il sert, comme indiqué précédemment, à adapter la plage de variation de tension du signal analogique binaire, qui est souvent de plusieurs dizaines de volts, à la plage de variation de tension admise par le circuit intégré ASIC, qui est en général comprise entre 0 et 5 volts et quelquefois moindre.

Le banc de triggers de Schmitt 1, 2, 3 placé en entrée du circuit proprement dit d'acquisition d'un signal analogique binaire est constitué d'au moins deux types différents de triggers de Schmitt dont les cellules dans le circuit intégré numérique ASIC ont été précaractérisées et font partie d'une bibliothèque de cellules à la disposition du concepteur de circuit intégré. Ces deux types sont par exemple le type CMOS avec une valeur d'hystérésis d'environ 1,9 volts entre les seuils de basculement haut et bas d'un trigger, et le type TTL avec une valeur d'hystérésis d'environ 0,6 volts entre les seuils de basculement haut et bas d'un trigger. Bien entendu, il peut y avoir d'autres types de trigger de Schmitt avec des valeurs différentes d'hystérésis. Il suffit pour cela, que ces autres types aient été précaractérisés et figurent dans la bibliothèque de cellule à disposition du concepteur de circuit intégré ASIC.

Le circuit logique de discrétisation 4 est un circuit logique combinatoire et/ou séquentiel, éventuellement même de type mémoire, qui déduit l'état du signal analogique binaire de la combinaison des états de sortie des différents triggers de Schmitt 1, 2, 3. Il peut être, comme représenté, à la figure 2 suivi d'un filtre numérique antibruit 8 et doublé par un circuit de détection de panne 9.

Le filtre numérique antibruit permet de s'affranchir des transitoires dus aux fonctionnements asynchrones des différents triggers de Schmitt. La capacité de filtrage 7 de l'étage analogique passif d'entrée joue alors le rôle de filtre anti-repliement nécessaire au bon fonctionnement de ce filtre numérique antibruit. '

Le circuit de détection de panne 9 est un circuit logique combinatoire et/ou séquentiel, éventuellement même de type mémoire, qui repère les combinaisons interdites des états de sortie des triggers de Schmitt 1, 2, 3 à des fins de détection de panne. Il émet un signal d'alarme lorsqu'il constate le maintien d'une combinaison interdite entre les états de sortie des différents triggers de Schmitt au delà d'une certaine durée.

La figure 3 illustre un mode de réalisation pratique d'un circuit pour l'acquisition d'un signal analogique binaire dans le cas fréquent, où la bibliothèque de cellules à la disposition du concepteur de circuit intégré ASIC ne renferme que deux types de trigger de Schmitt, l'un au standard CMOS, l'autre au standard TTL et où l'on désire augmenter l'hystérésis. On profite alors de l'étagement des seuils de basculement haut et bas des triggers de Schmitt de type CMOS et TTL résultant du fait que le seuil haut de basculement CMOS est supérieur au seuil haut de basculement TTL qui est lui même supérieur au seuil bas de basculement CMOS lui même supérieur au seuil bas de basculement TTL et l'on choisit d'avoir pour seuil haut de basculement le seuil haut de basculement au standard CMOS qui est le plus haut des seuils, et pour seuil bas de basculement le seuil bas de basculement du standard TTL qui est le plus bas des seuils. Le banc de triggers de Schmitt d'entrée est constitué d'un trigger de Schmitt au standard CMOS 10 et d'un trigger de Schmitt au standard TTL 11 et le circuit logique de discrétisation par un registre de mémorisation 12 actif sur niveau. Le registre de mémorisation 12 a une entrée donnée D portée au niveau logique + 1, une entrée d'autorisation d'inscription e connectée en sortie du trigger de Schmitt 10 au standard CMOS, une entrée complémentée de remise à zéro prioritaire nr connectée en sortie du trigger de Schmitt 11 au standard TTL et une sortie donnée Q. La sortie Q du registre de mémorisation 12 passe au niveau logique 1 chaque fois que le signal analogique binaire d'entrée franchit à la montée le seuil haut du standard CMOS et au niveau logique 0 chaque fois que le signal analogique d'entrée franchit à la descente le seuil bas du standard TTL. On obtient ainsi, pour le circuit pour l'acquisition d'un signal analogique binaire un seuil haut équivalent au plus haut des seuils hauts et un seuil bas équivalent au plus haut des seuils bas de ses triggers de Schmitt.

La figure 4 est un diagramme de courbes qui illustre ce fonctionnement. On y distingue :
- un signal d'entrée S de forme triangulaire franchissant au cours du temps l'ensemble des quatre seuils de basculement des triggers de Schmitt au standard CMOS et TTL à la montée puis à la descente,
- le signal e qui résulte, en sortie du trigger au standard CMOS 10, de l'application du signal d'entrée S et que l'on retrouve sur l'entrée d'autorisation d'inscription e du registre de mémorisation 12,
- le signal nr qui résulte, en sortie du trigger au standard TTL 11, de l'application du signal d'entrée S et que l'on retrouve sur l'entrée complémentée de remise à zéro prioritaire nr du registre de mémorisation 12, et
- le signal Q qui résulte en sortie Q du registre de mémorisation 12, de l'application du signal d'entrée S.

On remarque qu'il n'est pas utile de sensibiliser les triggers aux passages des seuils de basculement retenus car ils le sont nécessairement puisque les seuils de basculement retenus encadrent les deux autres seuils de basculement et que leurs franchissements successifs impliquent ceux des deux autres seuils de basculement.

Le même résultat aurait pu être obtenu en remplaçant le registre de mémorisation 12 du circuit logique de discrétisation par une porte logique de type "et".

Si l'on souhaite au contraire diminuer l'hystérésis, c'est-à-dire sélectionner pour seuil haut de basculement le seuil haut du trigger de Schmitt au standard TTL qui est le plus bas des seuils haut de basculement et pour seuil bas de basculement le seuil bas du trigger de Schmitt au standard CMOS qui est le plus haut des seuils bas de basculement, il ne suffit pas d'échanger les triggers de Schmitt aux standard CMOS et TTL. Il faut aussi compléter le montage conformément à la figure 5 d'une part, pour obliger le trigger au standard CMOS à seuil haut de basculement le plus élevé à basculer à l'état haut au franchissement en montée du seuil haut de basculement du trigger au standard TTL car le signal analogique binaire d'entrée peut franchir à la montée le seuil haut de basculement TTL sans atteindre le seuil haut de basculement CMOS et d'autre part, pour obliger le trigger au standard TTL à seuil bas de basculement le plus bas à basculer à l'état bas au franchissement en descente du seuil bas de basculement du trigger au standard CMOS car le signal analogique binaire d'entrée peut franchir à la descente le seuil bas de basculement du trigger au standard CMOS sans atteindre le seuil bas de basculement TTL.

On distingue sur cette figure 5, l'étage analogique passif d'entrée, extérieur au circuit intégré numérique ASIC, constitué du pont diviseur de tension à deux résistances 5, 6 complété par la capacité de filtrage 7. La sortie de cet étage analogique passif mène à un banc de deux triggers de Schmitt d'entrée, l'un 20 au standard CMOS et l'autre 21 au standard TTL, intercalés devant un circuit logique de discrétisation qui comporte :
- un premier registre de mémorisation 22 actif sur niveau, avec une entrée donnée D portée au niveau logique + 1, une entrée d'autorisation d'inscription e connectée en sortie du trigger de Schmitt 21 au standard TTL, une entrée complémentée de remise à zéro prioritaire nr connectée en sortie du trigger de Schmitt 20 au standard CMOS et une sortie de donnée Q délivrant le signal de sortie général du montage,
- un deuxième registre de mémorisation 23 actif sur niveau, avec une entrée donnée D portée au niveau logique +1, une entrée d'autorisation d'inscription e connectée en sortie du trigger de Schmitt 20 au standard CMOS, une entrée complémentée de remise à zéro prioritaire nr connectée en sortie du trigger de Schmitt 21 au standard TTL et une sortie de donnée Q,
- une première porte logique 24 de type "et" à deux entrées dont une est complémentée, connectée par son entrée complémentée à la sortie du trigger de Schmitt 20 au standard CMOS et par son entrée non complémentée à la sortie du trigger de Schmitt 21 au standard TTL,
- une deuxième porte logique 25 de type "et" à deux entrées dont une est complémentée, connectée par son entrée complémentée à la sortie de donnée Q du deuxième registre de mémorisation 23 et par son entrée non complémentée à la sortie de la première porte logique 24,
- une troisième porte logique 26 de type "et" à deux entrées non complémentées connectées l'une à la sortie de donnée Q du deuxième registre de mémorisation 23 et l'autre à la sortie de la première porte logique 24,
- un premier circuit numérique de sortie 27 à trois états avec une entrée de donnée portée au niveau logique + 1, une entrée d'inhibition connectée à la sortie de la deuxième porte logique 25 et une sortie de donnée connectée en réaction sur l'entrée du trigger de Schmitt 20 au standard CMOS, et
- un deuxième circuit numérique de sortie 28 à trois états avec une entrée de donnée portée au niveau logique 0, une entrée d'inhibition connectée à la sortie de la troisième porte logique 26 et une sortie de donnée connectée en réaction sur l'entrée du trigger de Schmitt 21 au standard TTL.

Lorsqu'ils ne sont pas inhibés, les circuits numériques de sortie 27, 28 imposent leur niveau de sortie + 1 ou 0 aux entrées des triggers de Schmitt 20, 21 en raison de l'impédance de sortie non nulle de l'étage analogique d'entrée utilisé pour la mise à l'échelle de la plage de variation du signal analogique binaire d'entrée.

Le premier circuit de mémorisation 22 du circuit logique de discrétisation, qui délivre le signal de sortie sur sa sortie de donnée Q, passe au niveau logique 1 chaque fois que le trigger de Schmitt 21 au standard TTL bascule à l'état haut et au niveau logique 0 chaque fois que le trigger de Schmitt 20 au standard CMOS bascule à l'état bas. On remarque que pour obtenir un fonctionnement en trigger de Schmitt avec comme seuil haut celui du standard TTL et comme seuil bas celui du standard CMOS, il faut que les deux triggers de Schmitt 20, 21 aux standards CMOS et TTL soient sensibles au passage l'un de son seuil bas lorsque le seuil haut de l'autre a été franchi, l'autre de son seuil haut lorsque le seuil bas de l'autre a été franchi, ce qui implique qu'ils aient vu auparavant le signal analogique binaire d'entrée franchir leur autre seuil dans le sens opposé. Cette condition n'est pas nécessairement réalisée pour toutes les formes d'ondes du signal analogique binaire d'entrée en particulier si l'excursion du signal ne traverse pas l'ensemble des seuils. Pour pallier cet inconvénient, on complète le premier registre de mémorisation 22 par des circuits de forçage qui modifient un cours instant l'amplitude du signal analogique binaire d'entrée pour garantir la sensibilité des triggers de Schmitt 20, 21 aux franchissements des seuils haut TTL et bas CMOS.

La première porte logique 24 détecte les instants durant lesquels le signal analogique binaire d'entrée a franchi en montant le seuil haut TTL mais n'a pas encore franchi le seuil haut CMOS, ou bien a franchi en descendant le seuil bas CMOS mais n'a pas franchi le seuil bas TTL. Son signal de sortie "sa1" repère ainsi les instants ou un forçage peut se révéler nécessaire de manière à rendre ultérieurement l'un des triggers sensible au franchissement de son seuil antagoniste.

Le deuxième registre de mémorisation 23 identifie celui des triggers de Schmitt 20, 21 qui est susceptible d'être forcé. Si sa sortie de donnée Q est au niveau logique 0, c'est que l'amplitude du signal analogique binaire d'entrée est passée en dessous du seuil bas TTL sans être encore repassée au dessus du seuil haut CMOS et que le seuil à forcer est éventuellement le seuil haut CMOS. Si sa sortie de donnée Q est au niveau logique 1, c'est que l'amplitude du signal analogique binaire d'entrée est passée au dessus du seuil haut CMOS sans être encore repassée en dessous du seuil bas TTL et que le seuil à forcer est éventuellement le seuil bas TTL.

La deuxième porte logique 25 combine un niveau logique 0 en sortie du deuxième registre de mémorisation 23 et un niveau logique 1 en sortie de la première porte logique 24 pour provoquer un forçage temporaire de l'amplitude du signal analogique binaire d'entrée au-delà du seuil haut de basculement du trigger au standard CMOS.

La troisième porte logique 26 combine un niveau logique 1 en sortie du deuxième registre de mémorisation 23 et un niveau logique 1 en sortie de la première porte logique 24 pour provoquer un forçage temporaire de l'amplitude du signal analogique binaire d'entrée en dessous du seuil bas de basculement du trigger au standard TTL.

Les diagrammes de la figure 6 illustrent la forme des différents signaux que l'on retrouve en différents points du schéma de la figure 5 pour un signal analogique binaire d'entrée S' évoluant entre le seuil haut de basculement CMOS et le seuil bas de basculement TTL, sans les atteindre pour autant. La courbe CMOS_out illustre la forme du signal en sortie du trigger de Schmitt 20 au standard CMOS compte tenu des effets des circuits de forçage. La courbe TTL_out illustre la forme du signal en sortie du trigger de Schmitt 21 au standard TTL compte tenu des effets des circuits de forçage. La courbe sa1 illustre la forme du signal de sortie de la première porte logique 24. On remarque qu'elle passe au niveau logique 1 à chaque fois qu'un forçage dans un sens ou dans l'autre peut s'avérer nécessaire. La courbe sa2 illustre la forme du signal de sortie de la deuxième porte logique 25. On remarque qu'elle passe au niveau logique 1 chaque fois qu'un forçage du signal analogique binaire d'entrée au-delà du seuil haut de basculement CMOS peut s'avérer nécessaire. La courbe sa3 illustre la forme du signal de sortie de la troisième porte logique 26. On remarque qu'elle passe au niveau logique 1 chaque fois qu'un forçage du signal analogique binaire d'entrée en deçà du seuil bas de basculement TTL peut s'avérer nécessaire. La courbe sl1 illustre la forme du signal sur la sortie de donnée Q du deuxième registre de mémorisation 23 et la courbe SORTIE la forme du signal en sortie du circuit logique de discrétisation.

On remarque que le premier registre de mémorisation 22 pourrait être remplacé par une porte logique de type "ou".

D'une façon plus générale, la constitution précise du circuit logique de discrétisation dépend du résultat que l'on recherche, c'est-à-dire des deux combinaisons des états de sortie des triggers de Schmitt de l'étage d'entrée que l'on désire associer aux deux états du signal analogique binaire. Il est même envisageable, lorsque le signal analogique binaire d'entrée peut être échangé, de prévoir un choix entre plusieurs sélections différentes de seuils haut et bas en connectant plusieurs circuits logiques de discrétisation différents en parallèle sur les sorties du banc de triggers d'entrée et en disposant un circuit sélecteur en sorties des différents circuits logiques de discrétisation.

Sur la figure 7, on a représenté de manière très schématique la puce d'un circuit intégré 30 sur son boîtier 31 pour illustrer les connexions par fils conducteur entre les broches de connexion 32 du boîtier 31 et les plages de connexion 33, 34 ou "pads" de la puce 30. Dans le cas du circuit pour l'acquisition d'un signal analogique binaire, les entrées des triggers de Schmitt sont en parallèle si bien qu'il est possible de relier leurs plages de connexion 33, 34 à une même broche de connexion 32, ce qui permet de limiter le nombre de broches de connexion du boîtier du circuit intégré. Dans ce cas, pour conserver la capacité de tester en production les seuils de chacun des triggers, on utilise la technique des chaînes de portes logique de type "non et" dite technique du "nand tree" en langage anglo-saxon. Dans cette technique, on utilise autant de chaînes de portes logiques de type "non et" qu'il y a de triggers de Schmitt connectés en parallèle à l'entrée des circuits d'acquisition de signal analogique binaire.

La figure 8 illustre la mise en oeuvre de la technique du "nand tree" dans le cas d'un circuit intégré numérique ASIC renfermant trois circuits pour l'acquisition d'un signal analogique binaire 40, respectivement 41 et 42 du même type que celui de la figure 3, ayant chacun les entrées de leurs deux triggers de Schmitt câblées à une même borne de connexion 400, respectivement 401 et 402 du boîtier du circuit intégré numérique ASIC. Il y a deux chaînes de portes logiques de type "non et" : une première 50, 51, 52, 53 pour tester les triggers de Schmitt de type CMOS et une deuxième 60, 61, 62, 63 pour tester les triggers de Schmitt de type TTL.

La chaîne pour tester les triggers de Schmitt de type CMOS présente une première porte logique 50 de type "non et" à deux entrées avec une entrée portée au niveau logique + 1 et l'autre raccordée à une borne de connexion spécifique 500 du boîtier du circuit intégré ASIC par l'intermédiaire d'un trigger de Schmitt. A la suite de cette première porte logique 50, il vient une deuxième porte logique 51 de type "non et " à deux entrées, avec une entrée raccordée à la sortie de la première porte logique 50 et une entrée connectée à la sortie du trigger de Schmitt de type CMOS d'un premier circuit d'acquisition 40. A la suite de cette deuxième porte logique 51, il vient une troisième porte logique 52 de type "non et" à deux entrées, avec une entrée raccordée à la sortie de la deuxième porte logique 51 et une entrée connectée à la sortie du trigger de Schmitt de type CMOS d'un deuxième circuit d'acquisition 41. A la suite de cette troisième porte logique 52, il vient d'autres portes logiques 53 de type "non et" à deux entrées raccordées de la même manière jusqu'à avoir fait le tour des triggers de Schmitt de type CMOS de tous les circuits d'acquisition 40, 41, 42, la dernière 53 ayant sa sortie raccordée à une borne de connexion individuelle 501 du boîtier du circuit intégré ASIC.

La chaîne pour tester les triggers de Schmitt de type TTL a une structure analogue avec différentes portes logiques de type "non et" à deux entrées 60, 61, 62, 63, et deux bornes de connexion individuelle sur le boîtier du circuit intégré ASIC, l'une 600 pour son entrée et l'autre 601 pour sa sortie.

Au cours d'un test au moyen de l'une des chaînes, toutes les entrées de la chaîne sont portées initialement au niveau logique + 1. Dans un premier temps, un niveau logique 0 est progressivement appliqué sur toutes les entrées de la chaîne en allant du début vers la fin de la chaîne. Puis, dans un deuxième temps un niveau logique + 1 est appliqué progressivement sur toutes les entrées de la chaîne en allant de la fin vers le début de la chaîne. Au cours de ces modifications progressives des niveaux logiques appliqués aux entrées de la chaîne on doit constater des commutations de niveau logique en sortie de chaîne qui sont dues chacune à la commutation isolée à la montée ou à la descente de l'un des triggers de Schmitt sous test et qui permettent en conséquence d'apprécier individuellement les seuils haut et bas de ces triggers.

## Revendications

1. Circuit pour l'acquisition d'un signal analogique binaire **caractérisé en ce qu'**il comporte en entrée, au moins deux triggers de Schmitt (10, 11) à seuils haut et bas de basculement étagés connectés en parallèle par leurs entrées et suivis en sortie d'au moins un circuit logique de discrétisation (4) changeant d'état d'une part, lors du passage au niveau logique 1 du trigger de Schmitt (10) ayant le seuil haut de basculement le plus élevé et, d'autre part, lors du passage au niveau logique 0 du trigger de Schmitt (11) ayant le seuil bas de basculement le plus bas.

2. Circuit selon la revendication 1, **caractérisé en ce que** le circuit logique de discrétisation (4) est une porte logique de type "et".

3. Circuit selon la revendication 1, **caractérisé en ce que** le circuit logique de discrétisation (4) est un registre de mémorisation (12) avec une entrée donnée D mise au niveau logique + 1, une entrée e d'autorisation d'inscription connectée à la sortie de l'un (10) des triggers de Schmitt et une entrée complémentée de remise à zéro nr connectée à la sortie de l'autre (11) des triggers de Schmitt.

4. Circuit pour l'acquisition d'un signal analogique binaire **caractérisé en ce qu'**il comporte en entrée, au moins deux triggers de Schmitt (20, 21) à seuils haut et bas de basculement étagés connectés en parallèle par leurs entrées et suivis en sortie d'au moins un circuit logique de discrétisation (4) changeant d'état d'une part, lors du passage au niveau logique 0 du trigger de Schmitt (20) ayant le seuil bas de basculement le plus élevé et, d'autre part, lors du passage au niveau logique 1 du trigger de Schmitt (21) ayant le seuil haut de basculement le plus bas et des moyens de rétroaction ( 23, 24, 25, 26, 27, 28) forçant un court instant le trigger de Schmitt (20) à seuil haut de basculement le plus elevé au franchissement de son seuil haut dès franchissement en montant du seuil haut de basculement de l'autre trigger de Schmitt (21) par le signal d'entrée, et le trigger de Schmitt (21) au seuil bas de basculement le plus bas au franchissement de son seuil bas dès le franchissement en descendant du seuil bas de basculement de l'autre trigger de Schmitt (20) par le signal d'entrée.

5. Circuit selon la revendication 4, **caractérisé en ce que** le circuit logique de discrétisation (4) est une porte logique de type "ou".

6. Circuit selon la revendication 4, **caractérisé en ce que** le circuit logique de discrétisation (4) est un registre de mémorisation (22) avec une entrée donnée D mise au niveau logique +1, une entrée e d'autorisation d'inscription connectée à la sortie de l'un (21) des triggers de Schmitt et une entrée complémentée de remise à zéro nr connectée à la sortie de l'autre (20) des triggers de Schmitt.

7. Circuit selon la revendication 1 ou la revendication 4, faisant partie d'un circuit intégré en boîtier, **caractérisé en ce qu'**il a ses différents triggers de Schmitt d'entrée raccordés en entrée à une même broche de connexion du boîtier du circuit intégré numérique.

8. Circuit selon la revendication 1 ou la revendication 4, dont plusieurs exemplaires font partie d'un même circuit intégré en boîtier, **caractérisé en ce que** le circuit intégré en boîtier est équipé de moyens de test individuel de chacun des seuils des triggers de Schmitt des différents exemplaires du circuit, lesdits moyens de test étant à base de chaînes de portes logiques de type "non et" connectées chacune en sortie d'un même type de triggers de Schmitt.

9. Circuit selon la revendication 1 ou la revendication 4, **caractérisé en ce qu'**il comporte en outre un filtre numérique antibruit (8) connecté en sortie du circuit logique de discrétisation (4).

10. Circuit selon la revendication 1 ou la revendication 4, **caractérisé en ce qu'**il comporte en outre un circuit logique de détection de panne (9) qui est connecté en entrée en parallèle sur le circuit logique de discrétisation (4) et qui détecte les combinaisons interdites entre états de sortie des différents triggers de Schmitt d'entrée (1, 2, 3).

11. Circuit selon la revendication 10, **caractérisé en ce que** le circuit logique de détection de panne (9) engendre un signal d'alarme en cas de maintien de combinaisons interdites entre états de sortie des différents triggers de Schmitt d'entrée (1, 2, 3) au delà d'une certaine durée.

12. Circuit selon la revendication 1 ou la revendication 4, **caractérisé en ce qu'**il comporte plusieurs circuits logiques de discrétisation différents (4) connectés en parallèle aux sorties des triggers de Schmitt d'entrée (1, 2, 3) et suivi d'un circuit de sélection du signal de sortie de l'un d'entre eux.

## Patentansprüche

1. Schaltung zur Erfassung eines analogen binären Signals, **dadurch gekennzeichnet, daß** es am Eingang mindestens zwei Schmitt-Trigger (10, 11) mit hohen und niedrigen gestuften Schaltschwellen umfaßt, die mit ihren Eingängen parallel geschaltet und am Ausgang von mindestens einer Diskretisierungslogikschaltung (4) gefolgt sind, die einerseits beim Übergang zum Logikpegel 1 des Schmitt-Triggers (10) mit der höheren hohen Schaltschwelle und andererseits beim Übergang zum Logikpegel 0 des Schmitt-Triggers (11) mit der niedrigeren niedrigen Schaltschwelle den Zustand ändert.

2. Schaltung nach Anspruch 1, **dadurch gekennzeichnet, daß** die Diskretisierungslogikschaltung (4) ein Logikgatter des Typs "UND" ist.

3. Schaltung nach Anspruch 1, **dadurch gekennzeichnet, daß** die Diskretisierungslogikschaltung (4) ein Speicherregister (12) mit einem auf den Logikpegel +1 gesetzten Dateneingang D, einem mit dem Ausgang eines (10) der Schmitt-Trigger verbundenen Schreibberechtigungseingang e und einem mit dem Ausgang des anderen (11) der Schmitt-Trigger verbundenen komplementierten Nullstellungseingang nr ist.

4. Schaltung zur Erfassung eines analogen binären Signals, **dadurch gekennzeichnet, daß** es am Eingang mindestens zwei Schmitt-Trigger (20, 21) mit hohen und niedrigen gestuften Schaltschwellen umfaßt, die mit ihren Eingängen parallel geschaltet und am Ausgang von mindestens einer Diskretisierungslogikschaltung (4) gefolgt sind, die einerseits beim Übergang zum Logikpegel 0 des Schmitt-Triggers (20) mit der höheren niedrigen Schaltschwelle und andererseits beim Übergang zum Logikpegel 1 des Schmitt-Triggers (21) mit der niedrigeren hohen Schaltschwelle den Zustand ändert, und Rückkopplungsmittel (23, 24, 25, 26, 27, 28), die kurzzeitig den Schmitt-Trigger (20) mit der höheren hohen Schaltschwelle bei Überschreitung seiner hohen Schwelle nach der Überschreitung der hohen Schaltschwelle des anderen Schmitt-Triggers (21) durch das Eingangssignal bei seinem Anstieg und den Schmitt-Trigger (21) mit der niedrigeren niedrigen Schaltschwelle bei Überschreitung seiner niedrigen Schwelle nach der Überschreitung der niedrigen Schaltschwelle des anderen Schmitt-Triggers (20) durch das Eingangssignal bei seinem Abstieg setzt.

5. Schaltung nach Anspruch 4, **dadurch gekennzeichnet, daß** die Diskretisierungslogikschaltung (4) ein Logikgatter des Typs "ODER" ist.

6. Schaltung nach Anspruch 4, **dadurch gekennzeichnet, daß** die Diskretisierungslogikschaltung (4) ein Speicherregister (22) mit einem auf den Logikpegel +1 gesetzten Dateneingang D, einem mit dem Ausgang eines (21) der Schmitt-Trigger verbundenen Schreibberechtigungseingang e und einem mit dem Ausgang des anderen (20) der Schmitt-Trigger verbundenen komplementierten Nullstellungseingang nr ist.

7. Schaltung nach Anspruch 1 oder Anspruch 4, die Teil einer integrierten Schaltung in einem Gehäuse ist, **dadurch gekennzeichnet, daß** ihre unterschiedlichen Eingangs-Schmitt-Trigger am Eingang mit einem gleichen Verbindungsstift des Gehäuses der digitalen integrierten Schaltung verbunden sind.

8. Schaltung nach Anspruch 1 oder Anspruch 4, deren mehrere Exemplare Teil einer gleichen integrierten Schaltung im Gehäuse bilden, **dadurch gekennzeichnet, daß** die integrierte Schaltung im Gehäuse mit Mitteln zum Einzeltest jedes der Schwellen der Schmitt-Trigger der verschiedenen Exemplare der Schaltung ausgerüstet ist, wobei die Testmittel hauptsächlich Ketten von Logikgattern des Typs "NICHT-UND" sind, die jeweils mit dem Ausgang eines selben Typs von Schmitt-Triggern verbunden sind.

9. Schaltung nach Anspruch 1 oder Anspruch 4, **dadurch gekennzeichnet, daß** sie auch ein mit dem Ausgang der Diskretisierungslogikschaltung (4) verbundenes digitales Rauschfilter (8) umfaßt.

10. Schaltung nach Anspruch 1 oder Anspruch 4, **dadurch gekennzeichnet, daß** sie auch eine Störungserkennungslogikschaltung (9) umfaßt, die am Eingang parallel zu der Diskretisierungslogikschaltung (4) geschaltet ist und die verbotene Kombinationen zwischen Ausgangszuständen der verschiedenen Eingangs-Schmitt-Trigger (1, 2, 3) erkennt.

11. Schaltung nach Anspruch 10, **dadurch gekennzeichnet, daß** die Störungserkennungslogikschaltung (9) ein Alarmsignal erzeugt, wenn verbotene Kombinationen zwischen Ausgangszuständen der verschiedenen Eingangs-Schmitt-Trigger (1, 2, 3) über eine gewisse Dauer hinaus anhalten.

12. Schaltung nach Anspruch 1 oder Anspruch 4, **dadurch gekennzeichnet, daß** sie mehrere unterschiedliche Diskretisierungslogikschaltungen (4) umfaßt, die parallel mit den Ausgängen der Eingangs-Schmitt-Trigger (1, 2, 3) verbunden sind und von einer Auswahlschaltung des Ausgangssignals von einer unter ihnen gefolgt sind.

## Claims

1. Circuit for the acquisition of a binary analogue signal, **characterized in that** it comprises at its input at least two Schmitt triggers (10, 11) with staged upper and lower switching thresholds with their inputs connected in parallel and with their outputs followed by at least one discretization logic circuit (4) which changes its state, on the one hand, when the Schmitt trigger (10) having the higher of the upper switching thresholds switches to logic level 1, and, on the other hand, when the Schmitt trigger (11) having the lower of the lower switching thresholds switches to logic level 0.

2. Circuit according to Claim 1, **characterized in that** the discretization logic circuit (4) is an "and" logic gate.

3. Circuit according to Claim 1, **characterized in that** the discretization logic circuit (4) is a storage register (12) with a data input D set to the logic level +1, a writing authorization input e connected to the output of one (10) of the Schmitt triggers and a self-compensating zero resetting input nr, connected to the output of the other Schmitt trigger (11).

4. Circuit for the acquisition of a binary analogue signal, **characterized in that** it comprises at its input at least two Schmitt triggers (20, 21) with staged upper and lower switching thresholds with their inputs connected in parallel and with their outputs followed by at least one discretization logic circuit (4) which changes its state, on the one hand, when the Schmitt trigger (20) having the higher of the lower switching thresholds switches to logic level 0, and, on the other hand, when the Schmitt trigger (21) having the lower of the upper switching thresholds switches to logic level 1, feedback means (23, 24, 25, 26, 27, 28) forcing the Schmitt trigger (20) with the higher of the upper switching thresholds to allow a momentary passage through its upper threshold during the rise of the input signal from the upper switching threshold of the other Schmitt trigger (21), and forcing the Schmitt trigger (21) with the lower of the lower switching thresholds to allow passage through its lower threshold as soon as the input signal descends through the lower switching threshold of the other Schmitt trigger (20).

5. Circuit according to Claim 4, **characterized in that** the discretization logic circuit (4) is an "or" logic gate.

6. Circuit according to Claim 4, **characterized in that** the discretization logic circuit (4) is a storage register (22) with a data input D set to the logic level +1, a writing authorization input e connected to the output of one (21) of the Schmitt triggers and a complementary zero resetting input nr, connected to the output of the other Schmitt trigger (20).

7. Circuit according to Claim 1 or Claim 4, forming part of an integrated circuit package, **characterized in that** it has the inputs of its various input Schmitt triggers connected to a single connecting pin of the digital integrated circuit package.

8. Circuit according to Claim 1 or Claim 4, where a plurality of copies of this circuit form part of a single integrated circuit package, **characterized in that** the integrated circuit package is provided with means for individual testing of each of the thresholds of the Schmitt triggers of the various copies of the circuit, the said testing means being based on chains of "nand" logic gates, each connected at the output of a single type of Schmitt trigger.

9. Circuit according to Claim 1 or Claim 4, **characterized in that** it additionally comprises a digital noise filter (8) connected to the output of the discretization logic circuit (4).

10. Circuit according to Claim 1 or Claim 4, **characterized in that** it additionally comprises a failure detection logic circuit (9) whose input is connected in parallel to the discretization logic circuit (4) and which detects prohibited combinations of the output states of the various input Schmitt triggers (1, 2, 3).

11. Circuit according to Claim 10, **characterized in that** the failure detection logic circuit (9) generates an alarm signal if prohibited combinations are maintained for more than a certain time between the output states of the various input Schmitt triggers (1, 2, 3).

12. Circuit according to Claim 1 or Claim 4, **characterized in that** it additionally comprises a plurality of different discretization logic circuits (4) connected in parallel to the outputs of the input Schmitt triggers (1, 2, 3) and followed by a circuit for selecting the output signal of one of them.
